# EUROPEAN PATENT SPECIFICATION

(11) **EP 2 894 950 B1**
(45) Date of publication and mention of the grant of the patent: **29.07.2020**
(21) Application number: 13368016.5
(22) Date of filing: 31.05.2013
(51) Int. Cl.: H05K 1/02, H01L 21/48, H05K 3/30, H01L 23/367, H01L 23/498, H01L 23/00, H01L 23/31, H05K 3/46

(54) **EMBEDDED HEAT SLUG TO ENHANCE SUBSTRATE THERMAL CONDUCTIVITY**
In Substrat eingebetteter Wärmeleitblock zur Verbesserung der Wärmeitung des Substrates
Dissipateur thermique encastré dans un substrat pour améliorer la conductivité de la chaleur du substrat

(43) Date of publication of application: 15.07.2015
(73) Proprietor: Dialog Semiconductor GmbH, 73230 Kirchheim/Teck-Nabern (DE)
(72) Inventor: Canete, Baltazar, 71334 Waiblingen (DE); Martin, Melvin, 70372 Stuttgart (DE); Kent, Ian, Caine, Wilts SN1 19UE (GB)
(74) Representative: Schuffenecker, Thierry

(56) References cited:
- WO-A1-2005/083807
- DE-A1- 10 035 170
- US-A- 4 835 598
- US-A1- 2002 185 718
- US-A1- 2005 145 414
- US-A1- 2010 264 798
- US-A1- 2012 199 955
- US-B1- 6 337 228
- US-B1- 6 373 348

## Description

### Technical Field

This disclosure is related to electronic packages, and more particularly, to improved heat dissipation in substrate-based electronic packages.

### Background Art

Electronic packaging technology demands smaller and more complex packages. A heat slug, or heat spreader, is a rectangular metal plate used to dissipate heat away from electronic devices. Typically, heat slugs are mounted on top of the package or die. This adds to manufacturing cost. If a heat slug is not used, junction temperature will increase, eventually leading to system failure.

U.S. Patents 5,642,261 (Bond et al), 5,285,352 (Pastore et al), and 6,282,094 (Lo et al) disclose heat slugs, but in these disclosures, the heat slug is packaged completely differently from the present disclosure.

US 2002/185718 discloses a semiconductor package comprising an LSI chip, a chip bump, an interposer, and a BGA bump is mounted at a predetermined position of a printed wiring board having a core layer. A heat sink for dissipating heat generated from the LSI chip is installed within the core layer. Further, heat radiating vias for conveying heat generated from the LSI chip to the heat sink are provided within the printed wiring board so that the BGA bump in the LSI chip is thermally liked with the heat sink. The heat generated from the LSI chip is mainly dissipated through a route of chip bump->interposer->BGA bump->heat radiating via->heat sink. By virtue of the above construction, the semiconductor device packaging structure can reduce the packaging volume of the heat sink while providing satisfactory cooling capacity and, at the same time, can minimize the length of signal wiring between LSI chips.

DE 100 35 170 discloses a ceramic body comprising surface sections ; thermal through-contacts connecting the surface sections to exchange heat between the sections; and a tempering device connecting one of the sections to receive and/or release heat.

US 6,373,348 discloses a high speed differential attenuator which is formed on low temperature co-fired ceramic substrate structure having first and second parallel resistor-capacitor divider networks with each divider network having first and second parallel resistors and capacitors.

US 2005/145414 discloses a metal-core multilayer printed wiring board which is obtained by forming one or more of at least inner layers of a laminate having a insulating layer and a conductor layer stacked alternately from a metal plate and has the metal plate as a core, the metal plate is disposed below a site on which a heating element is to be mounted, a surface layer over which the heating element is to be mounted is connected to the metal plate of the inner layer via a BVH and a heat radiation layer is formed over the surface layer.

US 2010464798 discloses a light emitting diode lamp including a light emitting diode and a circuit board having a circuit layer and a heat conductive layer. The circuit layer includes at least one mounting area having a first electrode, a second electrode and a heat conductive section spaced from each other. A heat conductive pole is provided corresponding to the heat conductive section. Two opposite ends of the heat conductive pole are thermally attached to the light emitting diode and the heat conductive layer of the circuit board, respectively. A spacing between the heat conductive section and each of the first electrode and the second electrode ranges from 0.7mm to 1.45mm.

US 2012/199955 discloses a manufacturing method of a package carrier is provided. A first opening communicating an upper surface and a lower surface of a substrate is formed. A heat-conducting element having a top surface and a bottom surface is configured in the first opening and fixed into the first opening via an insulation material. A first insulation layer and a first metal layer are laminated onto the upper surface. A second insulation layer and a second metal layer are laminated onto the lower surface. A second opening and a third opening respectively exposing portions of the top and the bottom surfaces are formed. At least one through via passing through the first metal layer, the first insulation layer, the substrate, the second insulation layer and the second metal layer is formed. A third metal layer covering the first and second metal layers and an inner wall of the through via is formed.

US 2002/185718 discloses a semiconductor package comprising an LSI chip, a chip bump, an interposer, and a BGA bump is mounted at a predetermined position of a printed wiring board having a core layer. A heat sink for dissipating heat generated from the LSI chip is installed within the core layer. Further, heat radiating vias for conveying heat generated from the LSI chip to the heat sink are provided within the printed wiring board so that the BGA bump in the LSI chip is thermally liked with the heat sink. The heat generated from the LSI chip is mainly dissipated through a route of chip bump->interposer->BGA bump->heat radiating via->heat sink. By virtue of the above construction, the semiconductor device packaging structure can reduce the packaging volume of the heat sink while providing satisfactory cooling capacity and, at the same time, can minimize the length of signal wiring between LSI chips.

### Summary of the invention

It is the primary objective of the present disclosure to embed a heat slug within a substrate.

Another objective of the present disclosure is to provide a method to improve the heat flow out of electronic devices in a package.

A further objective is to provide an electronic package having an embedded heat slug.

A yet further objective is to provide an electronic package in which a heat slug is embedded in the substrate dielectric layer and in which the heat slug is not exposed on its top or bottom side.

In accordance with the objectives of the present disclosure, a method of fabricating an electronic package, as defined in claim 8, is achieved. A substrate is provided having three or more layers, comprising a dielectric layer and a metal layer within the dielectric layer thermally connected to at least one metal layer on top of the dielectric layer and to at least one metal layer on bottom of the dielectric layer. A heat slug is embedded completely within the dielectric layer. A die is attached above the substrate. Thermal paths to the heat slug are linked through all of the metal layers.

Also in accordance with the objectives of the present disclosure, a method of fabricating an electronic package, as defined in claim 1, is achieved. A substrate is provided having three or more layers, comprising a dielectric layer and a metal layer within the dielectric layer thermally connected to at least one metal layer on top of the dielectric layer and to at least one metal layer on bottom of the dielectric layer wherein the thermally connected metal layers form ground signal interconnects. A heat slug is embedded completely within the dielectric layer. A die is attached above the substrate wherein the die has no direct connection to the heat slug. Thermal paths are linked to the heat slug through the ground signal interconnects.

Also in accordance with the objectives of the present disclosure, an electronic package is achieved. The electronic package comprises a substrate having three or more metal layers, comprising a dielectric core layer and a metal layer within the dielectric core layer thermally connected to at least one metal layer on top of the dielectric core layer and to at least one metal layer on bottom of the dielectric core layer. A die is attached above the substrate and a heat slug is embedded within the dielectric layer wherein the heat slug has no direct contact to the die and wherein the heat slug is thermally connected to each of the metal layers.

### Description of the drawings

In the accompanying drawings forming a material part of this description, there is shown:
Figs. 1-7 are cross-sectional representations of a method according to a first preferred embodiment of the present disclosure, using a three-layer substrate.
Fig. 8 is an exploded view of the layers in Fig. 7.
Figs. 9-13 are cross-sectional representations of a second preferred embodiment of the present disclosure, using an eight-layer substrate.

### Description of the preferred embodiments

The present disclosure provides an electronic package having improved heat flow as well as increased miniaturization. Embedding a heat slug within a substrate minimizes junction temperature increases without increasing the assembly process manufacturing cost. As far as the assembly process is concerned, mounting the heat slug on top of the die will increase the manufacturing cost since it will incur additional assembly process and will increase through-put time. However, substrate manufacturing is not part of the assembly process and as a result, will not affect assembly cost since the heat slug is already embedded inside the substrate prior to assembly manufacturing.

In the process of the present disclosure, a heat slug will be embedded in a substrate underneath the die, just below the die attach glue. This will enable the heat flow to be concentrated to the substrate. Other advantages of this concept are:
- Better thermal flux and faster heat dissipation
- Lower thermal resistance
- Flexible substrate routing
- Thinner package

This method should be applicable to all packages using a BT (Bismaleimide Triazine) rigid laminate substrate. For example, a ball grid array (BGA) package with wire bonds is shown. However, it is also possible to embed a heat slug in other packages, such as Flip Chip Chip Scale Package (FC-CSP), Land Grid Arrays (LGA), or System in Package (SIP).

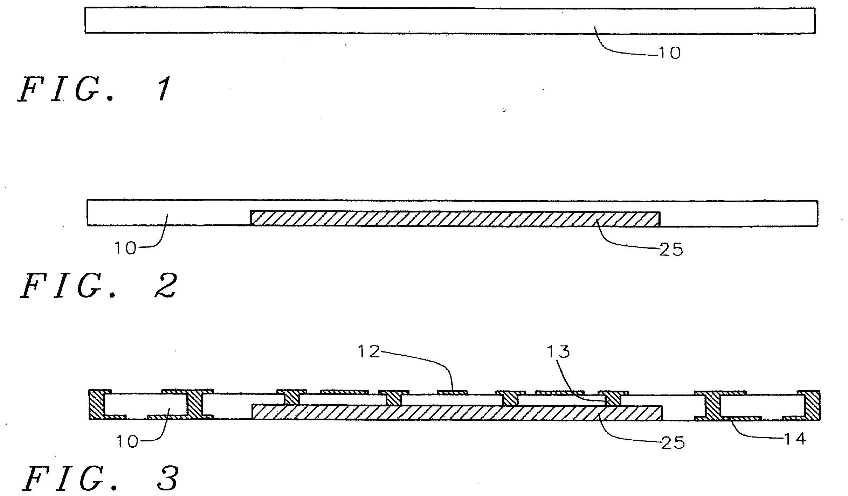

Referring now more particularly to Figs. 1-7, a preferred method of embedding a heat slug within a substrate will be described. Fig. 1 illustrates a core substrate 10. A standard substrate starts from a copper clad laminate with two metal (copper) layers separated by a dielectric core material. For example, this substrate includes a dielectric core material 10 and top and bottom copper layers. This will be built up by additional metal layers on top and/or bottom with prepregnated dielectric material for every stack/layer. The core layer will be cut to create a cavity area such that the heat slug can be placed inside. This cavity area may be drilled such as by laser or mechanical drilling.

Fig. 2 illustrates the heat slug 25 embedded in the cavity in the substrate core layer. In this embodiment, the cavity does not extend the entire depth of the core substrate.

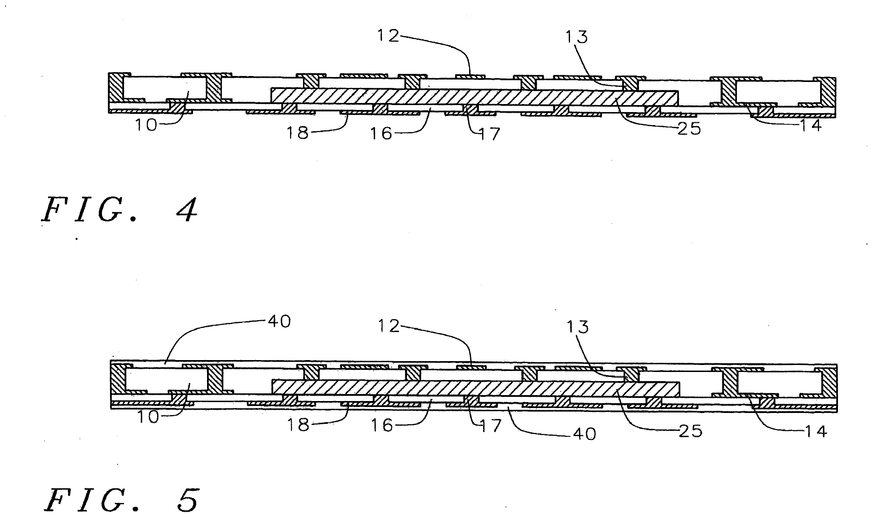

Now, a first metal layer 12 and second metal layer 14 are formed on the top and bottom of the core material 10, respectively. Thermal via connections 13 are formed in the first metal layer to connect to the heat slug 25 and to connect metal 12 and metal 14, as shown in Fig. 3. Succeeding build up layers will then be laminated on top and/or bottom of the core substrate. Fig. 4 shows a first build-up substrate comprising dielectric prepregnated material 16 laminated on the bottom of the core substrate. In an alternative, the heat slug may be embedded into the prepregnated material, not shown. Thermal via connections are made by copper layer 18 to the heat slug using lithography on the build-up layers, as shown in Fig. 4. Copper layer 18 also connects to copper layer 14, as shown.

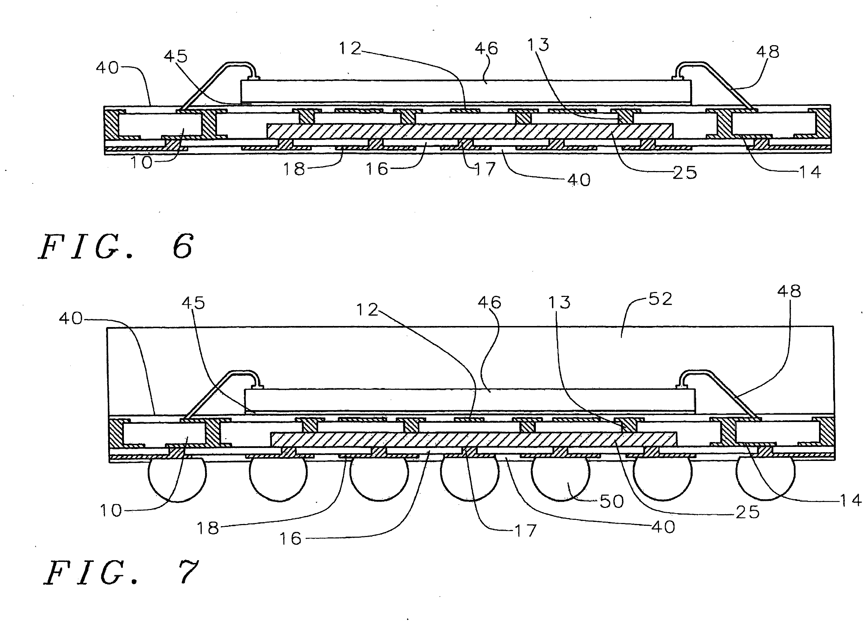

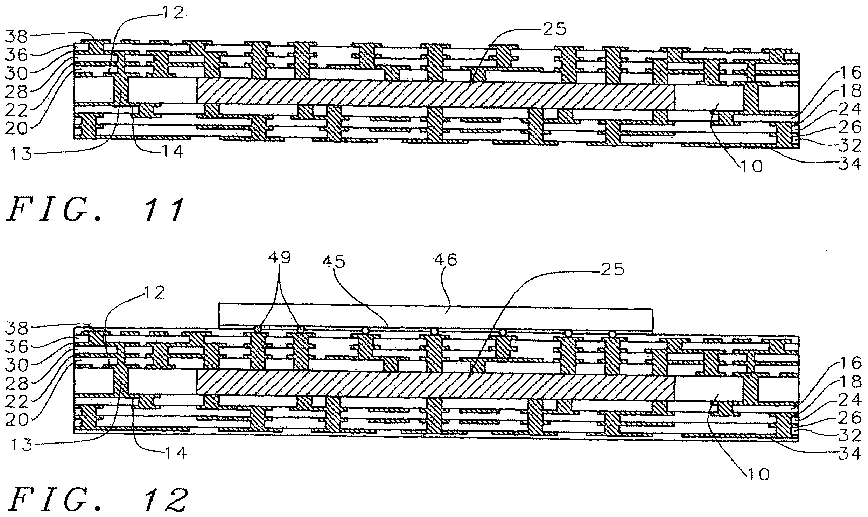

Now, in Fig. 5, a solder mask 40 is coated on the top and bottom of the build-up substrate. A die 46 is attached on top of the substrate using die attach material 45, such as Cu (copper), Au (gold), or CuPd (copper palladium), as shown in Fig. 6. Wire bonds 48 form wirebond connections between the die and metal layer 12. Alternatively, flip chip bumps 49 can be used in the case of FCCSP assemblies, as shown in Fig. 12.

The metal layers 12/14/17 are thermally connected, forming ground signal interconnects (traces, vias and planes). Ground planes are the metal layers that are internal to the substrates. These metal layers or planes are directly in contact with the heat slug; that is, the heat slug is linked to each of the ground metal layers (traces, planes and vias composing the ground net signals).

Fig. 7 shows molding compound 52 encapsulating the die 46. Solder balls 50 are attached to the bottom of the substrate. This completes the package.

The heat slug has no direct contact to the solder balls 50 or to the silicon die 46. All thermal connections or thermal paths are linked to the heat slug through the ground planes of all layers. On electronic packages, the die contains the components that generate heat. When power is inputted to the chip (or die) and the system turns on, heat is generated inside the chip. This heat will be dissipated throughout the package through the heat transfer process called conduction. With the help of the heat slug, a major percentage of heat can flow to the system printed circuit board (PCB), not shown. The PCB is a mounting board used by the end-customer and is not part of the electronic package.

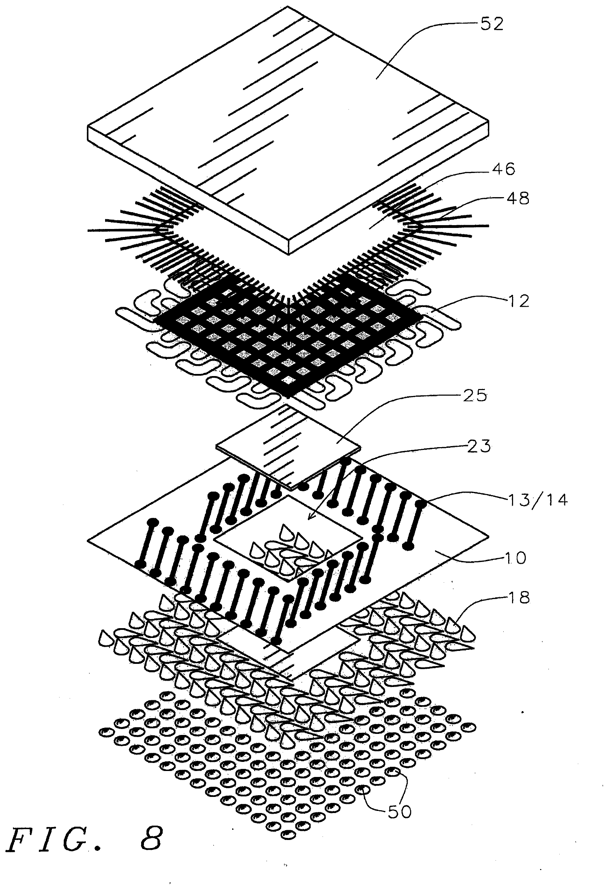

Fig. 8 illustrates an exploded view of the layers in Fig. 7. Solder balls 50 are shown at the bottom of Fig. 8. Next, is the bottom metal substrate layer 18. On top of layer 18 is the core material 10. Inner metal layer 14 and via connections 13 are also within this layer. The heat slug 25 is embedded in the core substrate 10 as shown by the cavity 23 in Fig. 8. Substrate top metal layer 12 is shown above the heat slug 25 and is connected to the inner metal layer 14 by via connections 13, shown in Fig. 3. Silicon die 46 and bond wires 48 are shown in the next to top layer in Fig. 8. Mold compound 52 is shown as the top layer.

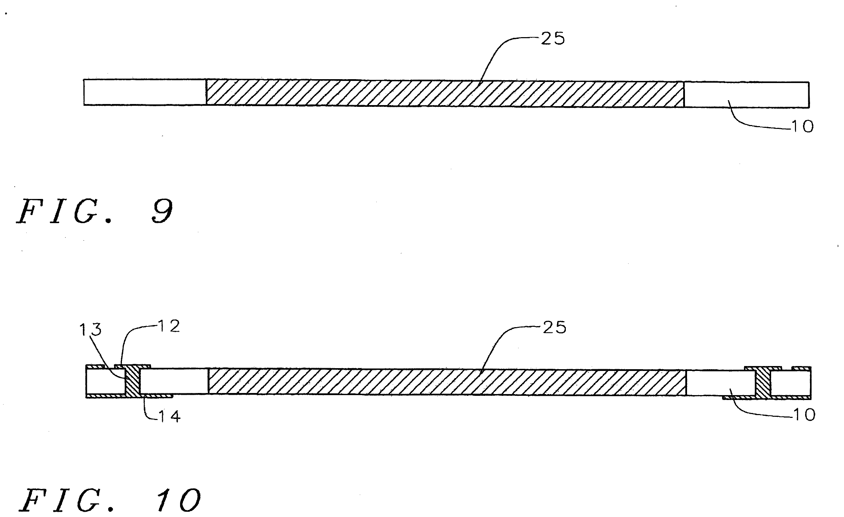

The embedded heat slug of the present disclosure is applicable to a substrate having three or more layers. Referring now more particularly to Figs. 9-13, a preferred method of embedding a heat slug within an eight-layered substrate will be described. Fig. 9 illustrates a core substrate 10 into which a cavity has been drilled. In this example, the cavity extends through the entire depth of the core substrate. Heat slug 25 is embedded in the cavity in the substrate core layer.

Now, a first metal layer 12 and second metal layer 14 are formed on the top and bottom of the core material 10, respectively. Thermal via connections 13 are formed in the first metal layer to connect to the heat slug 25 and to connect metal 12 and metal 14, as shown in Fig. 10. Succeeding build up layers will then be laminated on top and/or bottom of the core substrate.

Fig. 11 shows a first build-up substrate comprising dielectric prepregnated material 16 laminated on the bottom of the core substrate. Thermal via connections are made by copper layer 17 to the heat slug using lithography on the build-up layers, as shown in Fig. 11. Copper layer 17 also connects to copper layer 14, as shown. Additional build-up layers are laminated onto the top and/or bottom of the build-up substrate and lithography and copper-filled via is used to make the electrical and thermal connections to the heat slug and between metal layers. Fig. 11 illustrates prepregnated layers 16, 24, and 32 on the bottom of the substrate and metal layers 18, 26, and 34, on and through those layers, respectively. On the top of the substrate, prepregnated layers 20, 28, and 36 are successively laminated and connections made using copper layers 22, 30, and 38, respectively. This example shows eight metal layers. It will be understood that any number of metal layers, three or more could be used.

Now, in Fig. 12, a solder mask 40 is coated on the top and bottom of the build-up substrate. A die 46 is attached on top of the substrate using die attach material 45, such as Cu (copper), Au (gold), or CuPd (copper palladium). Flip chip bumps 49 make connections between the die and the metal layer 12. Alternatively, wire bonds 48 can be used, as shown in Fig. 5. All the metal layers are thermally connected, forming ground signal interconnects (traces, vias and planes).

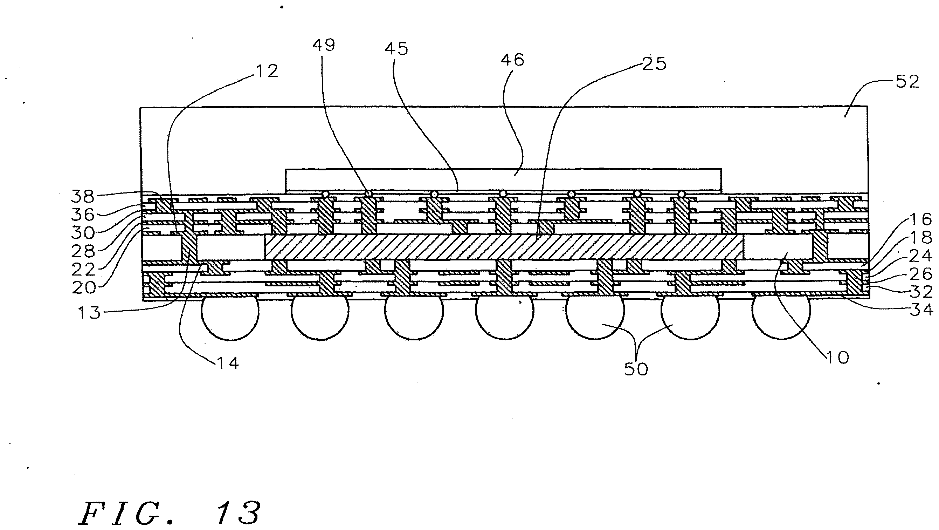

Fig. 13 shows molding compound 52 encapsulating the die 46. Solder balls 50 are attached to the bottom of the substrate. This completes the package.

The method and device of the present disclosure allow electronic packages to be thinner, which is advantageous for constructing smaller applications, such as mobile phones, for example. Another advantage is that electronic packages of the present disclosure can be allowed to dissipate more power than previous devices, which can be used in high performance chips.

A Finite Differential Modeling (FDM) technique was employed to assess thermal performance of the electronic package of the present disclosure. The simulation suggests that more heat is absorbed by the embedded heat slug of the present disclosure and that the heat dissipates quickly from the package going to the printed circuit board. Furthermore, copper traces can be routed away from the embedded heat slug using multilayer substrates making the design flexible.

## Claims

1. An electronic package comprising :
a die (46) and a heat slug (25) embedded within a dielectric layer (10),
a substrate having three or more metal layers (12, 13, 14), comprising a dielectric core layer (10), a metal layer (13) within said dielectric core layer thermally connected to at least one metal layer (12) on top of said dielectric core layer and to at least one metal layer (14) on bottom of said dielectric core layer;
said die (46) attached above said substrate;
**characterized in that**
said heat slug (25) has no direct contact to said die and wherein said heat slug is thermally connected to ground planes of each of said metal layers (12, 13, 14, 17, 18).

2. The package according to Claim 1 wherein said substrate is selected from the group containing a ball grid array substrate (BGA), a Flip Chip Chip Scale Package (FC-CSP), a Land Grid Array (LGA), and a System in Package (SIP)..

3. The package according to Claim 1 wherein said substrate is a build-up substrate comprising a prepregnated dielectric material layer laminated on one of said metal layers on top or bottom of said dielectric layer and a metal layer on said prepregnated material and connecting to an underlying metal layer and further comprising prepregnated dielectric material laminated on a metal layer on an underlying prepregnated material layer.

4. The package according to Claim 3 wherein said heat slug (25) is embedded within said dielectric core layer or within said prepregnated dielectric material.

5. The package according to Claim 1 further comprising wire bonds connecting said die to a topmost metal layer of said substrate.

6. The package according to Claim 1 further comprising flip chip bumps connecting said die to a topmost metal layer of said substrate.

7. The package according to Claim 1 wherein heat from said die is dissipated through said heat slug and said thermally connected metal layers.

8. A method of fabricating an electronic package comprising:
providing a substrate having three or more layers, comprising a dielectric layer (10) and a metal layer (13) within said dielectric layer thermally connected to at least one metal layer (12) on top of said dielectric layer and to at least one metal layer (14) on bottom of said dielectric layer;
embedding a heat slug (25) completely within said dielectric layer (10) ;
attaching a die (46) above said substrate; and
linking thermal paths to said heat slug through ground planes of all of said metal layers (12, 13, 14, 17, 18).

9. The method according to Claim 8 further comprising forming a build-up substrate comprising:
laminating a prepregnated dielectric material layer on one of said metal layers on top or bottom of said dielectric layer;
forming a metal layer on said prepregnated material and thermally connecting it to an underlying metal layer; and
laminating a second prepregnated dielectric material on a metal layer on an underlying prepregnated material layer; and
forming a second metal layer on said second prepregnated material and connecting it to an underlying metal layer; and
continuing this process until a desired number of substrate layers are formed.

10. The method according to Claim 8 wherein said substrate is selected from the group containing a ball grid array substrate (BGA), a Flip Chip Chip Scale Package (FC-CSP), a Land Grid Array (LGA), and a System in Package (SIP)..

11. The package according to Claim 9 wherein said heat slug is embedded within said dielectric core layer or within said prepregnated dielectric material.

12. The method according to Claim 8 further comprising connecting said die to a topmost metal layer of said substrate using wire bonds or flip chip bumps.

13. The method according to Claim 8 wherein heat from said die is dissipated through said heat slug and said thermal paths.

## Patentansprüche

1. Elektronisches Paket,umfassend:
eine Matrize (46) und einen in eine dielektrische Schicht (10) eingebetteten Heat-Slug (25),
ein Substrat mit drei oder mehr Metallschichten (12, 13, 14), umfassend eine dielektrische Kernschicht (10), eine Metallschicht (13) innerhalb der dielektrischen Kernschicht, die thermisch mit mindestens einer Metallschicht (12) auf der Oberseite der dielektrischen Kernschicht und mit mindestens einer Metallschicht (14) auf der Unterseite der dielektrischen Kernschicht verbunden ist;
wobei die Matrize (46) über dem Substrat angebracht ist;
**dadurch gekennzeichnet, dass**
der Heat-Slug (25) keinen direkten Kontakt mit der Matrize hat und wobei der Heat-Slug thermisch mit Masseebenen jeder der Metallschichten (12, 13, 14, 17, 18) verbunden ist.

2. Paket nach Anspruch 1, wobei das Substrat aus der Gruppe ausgewählt ist, die ein Ball-Grid-Array-Substrat (BGA), ein Flip-Chip-Chip Scale Package (FC-CSP), ein Land-Grid-Array (LGA) und ein System in Package (SIP) enthält.

3. Paket nach Anspruch 1, wobei das Substrat ein Aufbausubstrat ist, das eine vorimprägnierte dielektrische Materialschicht, die auf eine der Metallschichten auf der Ober- oder Unterseite der dielektrischen Schicht laminiert ist, und eine Metallschicht auf dem vorimprägnierten Material, die mit einer darunterliegenden Metallschicht verbunden ist, und ferner vorimprägniertes dielektrisches Material, das auf eine Metallschicht auf einer darunterliegenden Schicht aus vorimprägniertem Material laminiert ist, umfaßt.

4. Paketnach Anspruch 3, bei dem der Heat-Slug (25) in die dielektrische Kernschicht oder in das vorimprägnierte dielektrische Material eingebettet ist.

5. Paketnach Anspruch 1 umfasst ferner Drahtbondungen, die die Matrize mit einer obersten Metallschicht des Substrats verbinden.

6. Paketnach Anspruch 1 umfasst ferner Flip-Chip-Höcker, die die Matrize mit einer obersten Metallschicht des Substrats verbinden.

7. Paketnach Anspruch 1, bei der die Wärme von der Matrize durch den Heat-Slug und die thermisch verbundenen Metallschichten abgeführt wird.

8. Verfahren zur Herstellung einer elektronischen Baugruppe, umfassend:
Bereitstellen eines Substrats mit drei oder mehr Schichten, umfassend eine dielektrische Schicht (10) und eine Metallschicht (13) innerhalb der dielektrischen Schicht, die thermisch mit mindestens einer Metallschicht (12) auf der Oberseite der dielektrischen Schicht und mit mindestens einer Metallschicht (14) auf der Unterseite der dielektrischen Schicht verbunden ist;
Einbettung eines Heat-Slug (25) vollständig in die dielektrische Schicht (10) ;
Anbringen einer Matrize (46) über dem Substrat; und
Verbindung von Wärmepfaden zu dem Heat-Slugdurch die Bodenebenen aller Metallschichten (12, 13, 14, 17, 18).

9. Verfahren nach Anspruch 8, ferner umfassend die Bildung eines Aufbausubstrats mit:
Laminieren einer vorimprägnierten dielektrischen Materialschicht auf eine der Metallschichten auf die Ober- oder Unterseite der dielektrischen Schicht;
Bilden einer Metallschicht auf dem vorimprägnierten Material und thermische Verbindung mit einer darunter liegenden Metallschicht; und
Laminieren eines zweiten vorimprägnierten dielektrischen Materials auf eine Metallschicht auf eine darunterliegende Schicht aus vorimprägniertem Material; und Bilden einer zweiten Metallschicht auf dem zweiten vorimprägnierten Material und Verbinden dieser mit einer darunter liegenden Metallschicht; und
Fortsetzung dieses Prozesses, bis eine gewünschte Anzahl von Substratschichten gebildet ist.

10. Verfahren nach Anspruch 8, bei dem das Substrat aus der Gruppe ausgewählt wird, die ein Ball-Grid-Array-Substrat (BGA), ein Flip-Chip-Chip Scale Package (FC-CSP), ein Land-Grid-Array (LGA) und ein System in Package (SIP) enthält.

11. Verfahren nach Anspruch 9, bei dem der Heat-Slug in die dielektrische Kernschicht oder in das vorimprägnierte dielektrische Material eingebettet ist.

12. Verfahren nach Anspruch 8, ferner umfassend das Verbinden der Matrize mit einer obersten Metallschicht des Substrats unter Verwendung von Drahtbonds oder Flip-Chip-Höckern.

13. Verfahren nach Anspruch 8, bei dem die Wärme von der Matrize über den Heat-Slug und die Wärmepfade abgeführt wird.

## Revendications

1. Un assemblage électronique comprenant :
une matrice (46) et un barreau thermique (25) incorporé à l'intérieure d'une couche diélectrique (10),
un substrat ayant trois couches métalliques ou plus (12, 13, 14), comprenant une couche centrale diélectrique (10), une couche métallique (13) à l'intérieure de ladite couche centrale diélectrique connectée à au moins une couche métallique (12) au-dessus de ladite couche centrale et à au moins une couche métallique (14) sur le fond de ladite couche centrale diélectriques ;
ladite matrice (46) attachée au-dessus dudit substrat ;
**caractérisé en ce que** ledit barreau thermique (25) présente aucun contact direct avec ladite matrice et dans lequel ledit barreau thermique est connecté thermiquement à des plans de masse de chacune desdites couches métalliques (12, 13, 14, 17, 18).

2. L'assemblage selon la revendication 1, dans lequel ledit substrat est choisi au sein du groupe comprenant un substrat de réseau de grille à billes (BGA), un assemblage à taille de puce à protubérances (FC-CSP), un réseau de grille terrestre (LGA), et un assemblage de système (SIP).

3. L'assemblage selon la revendication 1 dans lequel ledit substrat est un substrat construit comprenant une couche de matériau diélectrique pré imprégné stratifiée sur une desdits couche métalliques sur le dessus ou le fond de ladite couche diélectrique et une couche métallique sur ledit matériau pré-imprégné et connectant à une couche métallique sous-jacente et comprenant en outre un matériau diélectrique pre-imprégné stratifié sur une couche métallique au-dessus d'une couche de matériau pré-imprégné sous-jacente.

4. L'assemblage selon la revendication 3 dans lequel ledit barreau thermique (25) est incorporé dans ladite couche centrale diélectrique ou à l'intérieur dudit matériau diélectrique pré-imprégné.

5. L'assemblage selon la revendication 1 comprenant en outre des soudures de fils connectant ladite matrice à une couche métallique la plus supérieure dudit substrat.

6. L'assemblage selon la revendication 1 comprenant en outre des plots de contact pour montage sur billes connectant ladite matrice à une couche métallique la plus haute dudit substrat.

7. L'assemblage selon la revendication 1 dans lequel la chaleur de la matrice est dissipée au travers ledit barreau thermique et lesdites couches métalliques connectées thermiquement.

8. Un procédé de fabrication d'un assemblage électronique comprenant :
fournir un substrat ayant trois couches ou plus, comprenant une couche diélectrique (10) et une couche métallique (13) à l'intérieure de ladite couche diélectrique connectée thermiquement à au moins une couche métallique (12) au-dessus de ladite couche diélectrique et à au moins une couche métallique (14) sur le fond de ladite couche diélectrique ;
intégrer complètement un barreau thermique (25) avec ladite couche diélectrique (10) ;
attacher une matrice (46) au-dessus dudit substrat ; et
connecter des chemins thermiques audit barreau thermique via des plans de terre de toutes lesdites couches métalliques (12, 13, 14, 17, 18).

9. Le procédé selon la revendication 8 comprenant en outre la formation d'un substrat construit comprenant :
stratifier une couche de matériau diélectrique pré imprégné sur une desdites couches métallique au dessus ou sur le fond de ladite couche diélectrique ;
former une couche métallique sur ledit matériau pré imprégné et le connecter thermiquement à une couche métallique sous-jacente ; et
stratifier un second matériau diélectrique pré-imprégné sur une couche métallique sur une couche de matériau pré-imprégné sous-jacente ; et
former une seconde couche métallique sur ledit second matériau pré-imprégné et le connecter à une couche métallique sous-jacente ; et
poursuivre le procédé jusqu'à la formation d'un nombre désiré de couches de substrat.

10. Le procédé selon la revendication 8 dans lequel ledit substrat est choisi au sein du groupe comprenant un substrat de réseau de grille à billes (BGA), un assemblage à taille de puce à protubérances (FC-CSP), un réseau de grille terrestre (LGA), et un assemblage de système (SIP).

11. Le procédé selon la revendication 9 dans lequel ledit barreau thermique (25) est incorporé dans ladite couche centrale diélectrique ou à l'intérieur dudit matériau diélectrique pré-imprégné.

12. Le procédé selon la revendication 8 comprenant en outre la connection de ladite matrice à une couche métallique la pus haute dudit substrat en utilisant des soudures de fils ou des billes pour connexion à billes.

13. Le procédé selon la revendication 8 dans lequel la chaleur de ladite matrice est dissipée au travers ledit barreau thermique et lesdits chemins thermiques.
